# EUROPEAN PATENT SPECIFICATION

(11) **EP 0 386 836 B1**
(45) Date of publication and mention of the grant of the patent: **20.07.1994**
(21) Application number: 90200494.4
(22) Date of filing: 02.03.1990
(51) Int. Cl.: H03J 7/18, H04H 1/00

(54) **Method of processing a radio data signal and receiver for performing said method**
Verfahren zum Verarbeiten eines Rundfunkdatensignals, sowie Empfänger zum Durchführen dieses Verfahrens
Procédé de traitement d'un signal de données radio et récepteur pour la mise en oeuvre de ce procédé

(30) Priority: 08.03.1989 NL 8900565
(43) Date of publication of application: 12.09.1990
(73) Proprietor: Philips Electronics N.V., 5621 BA Eindhoven (NL)
(72) Inventor: Kamalski, Theodor Ignatius Eduard, NL-5656 AA Eindhoven (NL)
(74) Representative: Schoonheijm, Harry Barend

(56) References cited:
- DE-A- 3 149 409
- DE-A- 3 448 043
- DE-A- 3 620 428

## Description

The invention relates to a method of processing digital information of a radio data signal which is transmitted in a radio broadcasting signal with reference to at least first and second program identification codes of first and second program signals, respectively, and to a plurality of alternative frequencies per program identification code, said alternative frequencies being stored in first and second frequency lists allocated to the first and second program identification codes. The invention also relates to an FM radio receiver for receiving a digital radio data signal incorporated in an FM radio broadcasting signal, said receiver comprising an FM receiver section for tuning to a desired FM radio broadcasting signal and for processing the digital radio data signal into digital information relating to alternative frequencies which are grouped at least in accordance with first and second program identification codes, a control circuit and a memory circuit comprising at least first and second arrays of memory sites for storing the alternative frequencies grouped in accordance with the first and second program identification codes in first and second frequency lists, respectively, and a reception quality detector controlled by the control circuit.

Such an FM radio receiver in which the said method is performed is known as a car radio of the type indication Philips DC 682.

The known FM receiver has a plurality of push-buttons to which a number of programs can be allocated. With each push-button a memory bank in which a plurality of data associated with a given program can be stored can be activated. For example, in each memory bank the program identification code (PI code) of the program allocated to the relevant push button is stored together with a list of alternative frequencies (AFs), and possibly also the program service name (PS name), TP/TA, PTY, PIN and PTY code of the actual transmitter. For a further explanation of the significance of these codes reference is made to the EBU document Technical 3244E of March 1984, entitled "Specifications of the radio data system RDS for VHF/FM sound broadcasting".

Tuning to a desired program is possible by briefly depressing the push-button to which this program is allocated so that the memory bank corresponding to this push-button, for example the said first memory bank is activated for reading. The AFs in the frequency list of this first memory bank refer to radio data signal (RDS) transmitters each transmitting a mutually equal program signal with a mutually equal PI code allocated to this memory bank. The control circuit tunes the FM receiver for a short period to each of the AFs of this first list and activates the reception quality detector for measuring the reception quality of the RF radio broadcasting signal at each of these AFs. Subsequently, the AF having the best reception quality is determined, whereafter the receiver is tuned to the transmitter to which the last-mentioned AF relates. The reception quality of the last-mentioned so-called actual transmitter and that of each of the transmitters to which the other AFs in the first frequency list relate is constantly updated and compared. If the reception quality of the actual transmitter deteriorates to below an acceptable level, for example, due to changing reception conditions, the tuning is changed over to the AF having the best reception quality at that moment.

Another receiver arrangement for the optimisation of the reception quality is known from DE-A-3 149 409.

However, in practice it occurs that at the alternative frequencies in such a frequency list allocated to a given program identification code not only RDS transmitters transmitting program signals corresponding to this program identification code can be received, but also RDS transmitters which transmit other program signals and do not belong to the network of the actual transmitter. This may happen, for example at the national borders, or with non-RDS transmitters or so-called pirates, hereinafter briefly referred to as unwanted transmitters. The AFs at which, dependent on the location of the FM receiver, either an RDS transmitter with the desired program signal or an unwanted transmitter is received can only be recognized in the known FM receiver by the absence of the desired program identification code in the radio broadcasting signal of the unwanted transmitter. However, such a recognition is rather time-consuming. If the reception quality of an unwanted transmitter during a ride with the known car radio through a certain region instantaneously exceeds that of the actual transmitter, the program is tuned to such an unwanted transmitter and the user is confronted with an unwanted program. Only after the transmitter has been recognized as an unwanted transmitter by the absence of the desired PI code is a subsequent tuning change realised at which tuning to another unwanted transmitter is not unimaginable.

It is an object of the invention to provide a method and an FM receiver suitable for performing this method with which a reliable and rapid recognition of RDS transmitters conveying the desired program signal is possible, also in regions with a comparatively large number of unwanted transmitters.

According to the invention, a method of the type described in the opening paragraph is characterized in that a frequency pair is formed from at least one alternative frequency in the first frequency list and an alternative frequency in the second frequency list, if the transmitters to which the two alternative frequencies relate have a substantially mutually equal transmitter location and transmitter range, the reception quality of the RF radio broadcasting signal of each transmitter of the frequency pair being measured and compared with a quality criterion and a flag signal being generated and applied to a flag signal processing unit if the reception quality of each one of the two alternative frequencies satisfies the quality criterion.

An FM receiver suitable for performing this method according to the invention is characterized in that the control circuit comprises means for forming for forming a frequency pair from an alternative frequency in the first frequency list and an alternative frequency in the second frequency list, if the transmitters to which the two alternative frequencies relate have a substantially mutually equal transmitter location and transmitter range, means for activating the reception quality detector for measuring the reception quality of the RF radio broadcasting signal of each transmitter of the frequency pair, a comparison circuit for comparing the reception quality of said two transmitters with a quality criterion, a flag signal generating arrangement for generating a flag signal if the reception quality of each one of the two transmitters satisfies the quality criterion, and a flag signal processing circuit for processing the flag signal.

The invention is based on the recognition that it often occurs in practice that broadcasting programs are transmitted by one and the same RDS transmitter installation or transmitter tower, of course at mutually different RF carrier frequencies and with mutually different PI codes.

When using the measure according to the invention, a so-called mapped frequency pair is formed from the alternative frequencies (AFs) corresponding to these RF carrier frequencies in the different frequency lists in the case of two AFs with mutually different programs, while a mapped frequency trio is formed in the case of three different AFs, etc. to an n-fold frequency set in the case of an n number of AFs. The information indicating which AFs are associated with such a set may already be provided, for example in a ROM memory, or it may be introduced by the user or transmitted in a recently defined radio data signal group code word or the so-called type 14 group, also referred to as the Enhanced Other Network, or EON code word. Since the risk of unwanted transmitters occurring at each one of the two frequencies of such a mapped frequency pair is negligibly small, being generally in a frequency set with n frequencies pⁿ, in which p is the risk of tuning to an unwanted transmitter when changing over to an AF as in the known FM RDS receiver, the measure according to the invention leads to a reliable recognition of desired RDS transmitters. Since the reception quality can be measured within an inaudibly short period of time, a recognition in the way according to the invention is also many times faster than a recognition by means of detecting the absence of the desired PI code.

The formation of a set of frequencies from a number of AFs relating to transmitters conveying different program signals but having a substantially equal transmitter location and transmitter range can be automated in a preferred embodiment of the method according to the invention which is characterized by a detection of a code word incorporated in the radio data signal and preceding two alternative frequencies which jointly form a frequency pair.

When using this measure the afore-mentioned EON code word transmitted in the radio data signal is used, which provides the possibility of transmitting the AFs of a mapped frequency pair in a third block of this word, preceded by a mapped frequency code (MF code) incorporated in a second block of this word.

For further details about this type 14 group reference is made to the non-published British Patent Application no. 8829274.3.

In a further preferred embodiment which is characterized in that the flag signal processing unit enables only a change-over of the tuning between the alternative frequencies of a frequency set provided with a flag signal, the recognition of RDS transmitters according to the invention is used for preventing erroneous tuning change-overs to unwanted transmitters in an inaudible manner.

The invention will now be described in greater detail by way of example with reference to the accompanying drawings in which
Fig. 1 shows the defined EON group code word;
Fig. 2 shows an FM receiver according to the invention;
Fig. 3 shows a method of processing the radio data signal according to the invention.

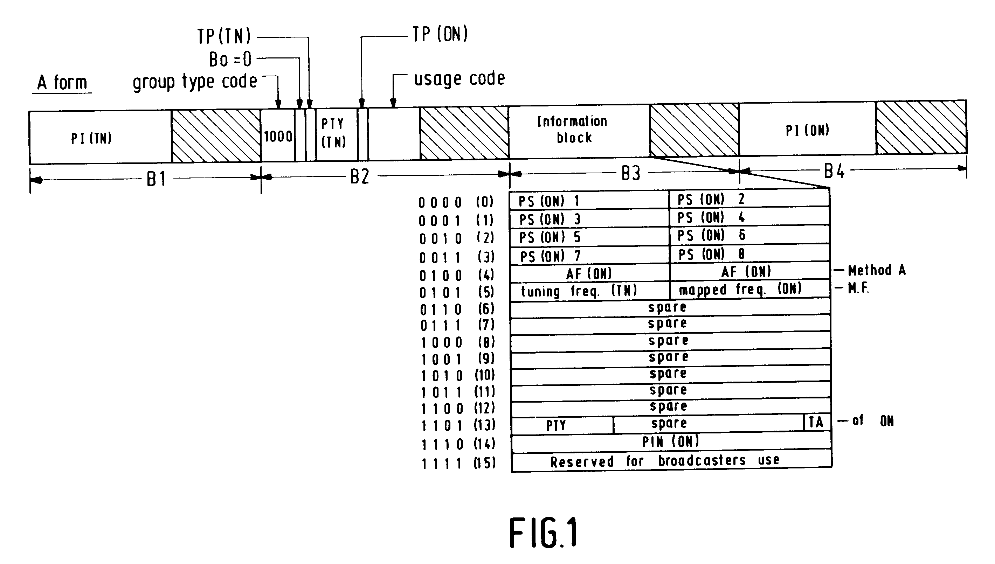

Fig. 1 shows version A of a recently defined group code word which can be transmitted in a digital signal (RDS) of an FM radio broadcasting signal and which is referred to as the so-called type 14 group or the EON (enhanced other network) code word. The EON code word is intended to transmit and update information relating to the AF, PTY, PS, TP, TA and PIN code of programs other than the actual program, i.e. other than the program of the transmitter to which the receiver is actually tuned. In this function the EON code word corresponds to the previously defined ON (other network) or type 3 group code word. However, the transmission of the above-mentioned information by means of the EON code word is much less sensitive to interference than the transmission by means of the ON code word because, unlike the ON code word, the PI code of the program to which the said information relates is repeated in each transmitted EON code word.

The EON code word comprises first to fourth subsequent blocks each having 16 information bits. The first block B1 gives the PI code of the actual program PI(TN), the second block B2 gives a group type code (group type 14), a version code BO (version A), a traffic information or a program type code relating to the actual program TP(IN) and PTY(IN), a traffic information code of another program TP(ON), and a 4-bit usage code (UC).

The UC refers to the information in the third block B3 in the manner shown in the Figure. The bit series 0101 for the UC indicates that two frequencies are incorporated in this third block B3, the first frequency being a frequency with a program signal corresponding to the program signal of the actual transmitter - hereinafter referred to as an AF associated with the actual network TN -. The second frequency is the frequency of a transmitter with a program signal which deviates from that of the actual transmitter - hereinafter referred to as an AF associated with another network ON - and with, a transmitter location and transmitter range of which at least the transmitter location substantially corresponds to that of the actual transmitter. These two frequencies thus overlap each other with regard to their transmitter range and are therefore referred to as overlapping, or mapped frequencies (MFs). The PI code of the program of the transmitter ON is incorporated in the fourth block B4. For a further description of the significance of these codes reference is made to the above-mentioned EBU document.

In a subsequent EON code word another AF in the list of the actual transmitter, i.e. the TN AF list, can be paired with an AF in the frequency list of the said other network, i.e. the ON AF list. This may be repeated for the AFs in the AF list of yet another network. In this way there may not only be a mapped relationship between the AFs of two frequency lists, but also between the AFs of three or more frequency lists. The AFs associated with a frequency set (i.e. frequency pair, trio, quartet, etc.) mutually have the above-mentioned mapped relationship. The signal reception quality of the transmitters to which the AFs of such a frequency set relate will be mutually substantially equal at any location within the transmitter range in the case of equal transmitter powers or have a ratio which is mutually dependent on one of these transmitter powers in the case of unequal transmitter powers. If the AFs of such a set of frequencies mutually deviate in reception quality in the case of equal transmitter powers, or deviate in the case of unequal transmitter powers in reception quality from the mutual ratio of these transmitter powers, tuning to these AFs is prevented or at least these AFs are identified as unwanted transmitters.

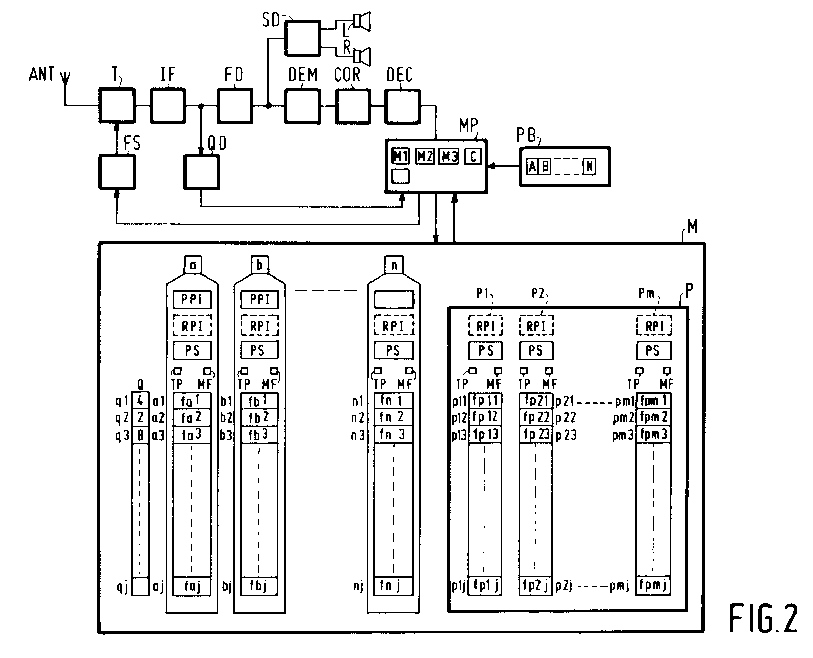

Fig. 2 shows an FM receiver according to the invention having an FM receiver section comprising a tuning section T to which an intermediate frequency section IF, a frequency detector FD, an RDS demodulator, an error correction and block-synchronizing circuit COR and an RDS decoder DEC are successively coupled. RF FM broadcasting signals are applied from an antenna device ANT to the FM receiver section in which tuning to a desired FM RF broadcasting signal is effected and in which a modulated digital RDS signal possibly incorporated therein is processed to digital RDS information.

An output of the frequency detector FD is coupled to a stereo decoder and audio signal processing unit SD, which supplies left and right stereo signals to left and right stereo loudspeakers L and R.

The stereo decoder DEC supplies digital RDS information to a control circuit MP which is coupled to a memory circuit M and to which the user can give tuning commands from an operating panel PB. The operating panel PB has a number of tuning keys A-N by means of which the user can activate a number of memory banks a-n of the memory circuit M via the control circuit MP. Each of these memory banks a-n comprises memory sites PPI, RPI, PS, TP and MF as well as an array of memory sites (1.....j) in which it is possible to store respectively a preset PI code, or the PI code of the actual program also referred to as the actual PI code, the program service (PS) name of the actual program, a flag for indicating a traffic message (TP), a flag for indicating a mapped relationship between the AFs of the relevant AF list with that of the actual transmitter frequency as well as a frequency list of a maximum number of j frequencies of transmitters having the same program as the actual transmitters, briefly referred to as AF list.

The memory circuit M also comprises an auxiliary memory P with pool stores p1-pm, which cannot be directly activated by the user. Each of these pool stores p1-pm has memory RPI, PS, TP and MF as well as an array of memory sites (1...j) corresponding in function to the likewise memory sites of the memory banks a-n. They are used for storing data of programs having a given relationship with the programs stored in the memory banks a-n or having certain messages which are often desired, such as, for example traffic messages. The storage of program data in the auxiliary memory P is realised by the control device MP which automatically allocates, inter alia programs with a PI code, the last two hexadecimal characters of which correspond to the PI code of the programs attached to the memory banks a-n, to a number of the pool stores p1-pm in which the PI code, PS name, TP and MF information and an AF list are stored. Also programs which are coupled via the EON code word to a program which is attached to one of the memory banks a-n and/or programs with traffic information can be automatically allocated to a number of pool stores p1-pm. The processing steps required for this purpose can be realised by means of a suitable program in the control circuit M.

The user can allocate preset programs to each tuning key A-N in known manner by storing the PI codes of these preset programs at the memory sites PPI of the memory banks a-n. When selecting an FM-RDS broadcasting signal with a given PI code, tuning will be effected at, for example fa1 which is stored at memory site a1 if the PI code of the desired program corresponds to that of the memory bank a. Via the so-called type OA group the AF list of this memory bank a is filled with the AFs fa2-faj associated with the actual transmitter frequency fa1 and the reception quality of the RF-FM broadcasting signal at each of these AFs including fa1 is measured in known manner, stored in a memory bank Q with memory sites q1-qj which correspond to memory sites a1-aj, respectively, and updated continuously. To this end the control circuit MP tunes the tuning section T via a frequency synthesis circuit FS to each of the AFs for a short period of time and the reception quality detector QD measures the reception quality, for example by way of the field strength and/or multipath reception of the RF-FM broadcasting signal of the relevant AF. If the signal reception quality at, for example fa3 is better than at the aforementioned fa1, the tuning is changed over from fa1 to fa3.

When receiving an EON code word, the presence of the beforementioned series 0101 in the UC in the second block is detected in a code word detector in the control circuit MP. If this bit series occurs, two AFs of a frequency pair follow in the third block B3, the first AF referring to the actual network (TN) and the second referring to the so-called other network (ON) whose PI code is mentioned in the fourth block B4. When detecting the said bit series in the UC in the second block B2, the said second frequency (ON) in the third block B3 of the EON code word is stored in the memory bank with the PI code of the other network PI-(ON) at a memory site which corresponds to the memory site of the first frequency (TN) in the AF list of the actual transmitter frequency mentioned in the third block B3. If the said PI code of the other network PI(ON) is allocated to none of the memory banks a-n, the control circuit MP allocates this PI code PI(ON) to one of the pool stores p1-pm of the auxiliary memory P.

For example, the frequencies fax and respectively fkx mentioned as a mapped frequency pair in the third block B3 will be stored in the array of memory sites of the memory bank a and respectively that of the memory bank or pool store k, at mutually corresponding memory sites x. In this way memory sites of the memory banks and pool stores are pair-wise filled with lists of frequencies of mapped frequency pairs (MF pairs) at corresponding memory sites. Both frequencies of such a frequency pair relate to mutually substantially equal transmitter locations and to a transmitter power or transmitter range which is known beforehand and which is equal in most cases.

In practice it may occur that more than two transmitters, for example three, four or n transmitters transmit mutually different programs in a mutually substantially identical transmitter range. This so-called mapped relationship can be transferred in the manner described above via a number of EON words and can be used to store these frequencies at corresponding memory sites in the relevant three, four or n number of arrays of memory sites of the memory banks and/or pool stores, thus forming a mapped frequency trio, quartet or generally a frequency set, for example the frequency trio fax, fbx, fcx; the frequency quartet fax, fbx, fcx, fdx or the frequency set fax, ..., fnx. The same method of storage at mutually corresponding memory sites is used for the other AFs in the AF lists of the said pool stores which jointly form a frequency set.

The non-active memory banks and pool stores whose AFs form a frequency set with the AFs of the active one, in the given case, for example the memory bank a, are provided with a mapped frequency indication bit at the memory site MF of each of these non-active memory bank and pool stores.

If the reception quality of the actual transmitter signal decreases below an acceptable minimum and if the signal quality at another AF is higher than this minimum or even has the highest occurring quality, or if the signal reception quality of the actual transmitter is exceeded by the reception quality of the said other AF, for example due to passing through a certain region, a change-over to this other AF will have to be effected, for example from fa3 to fax. According to the invention, the signal reception quality at the mapped frequency or frequencies of fax, i.e. at fbx in the given example and also at fcx and fdx in the case of a frequency trio or quartet is firstly measured and compared with that of fax. The AF lists whose AFs have a mapped relationship with the AF list of the active memory banks or pool store are recognizable by the said mapped frequency indication bit. If the signal reception quality at the frequencies of such a pair, trio, quartet, etc. is known beforehand and is substantially mutually equal in the case of mutually equal transmitter powers, a flag signal is generated in a flag signal generating circuit FG of the control circuit MP. This signal is applied to a flag signal processing circuit FP which uses the flag signal to authorize a change-over to the relevant AF, in this case fax. Generally it holds for a probability p of unwanted tuning to a pirate that the probability is p², p³, p⁴, etc. when using the invention on the basis of a frequency pair, trio, quartet, etc., respectively.

It will be obvious that the flag signal can be used in different ways. For example, it is quite possible to have storage in the memory circuit of an AF received via the RDS signal depend on the flag signal or to use the flag signal as an indication for the reception of an RDS signal.

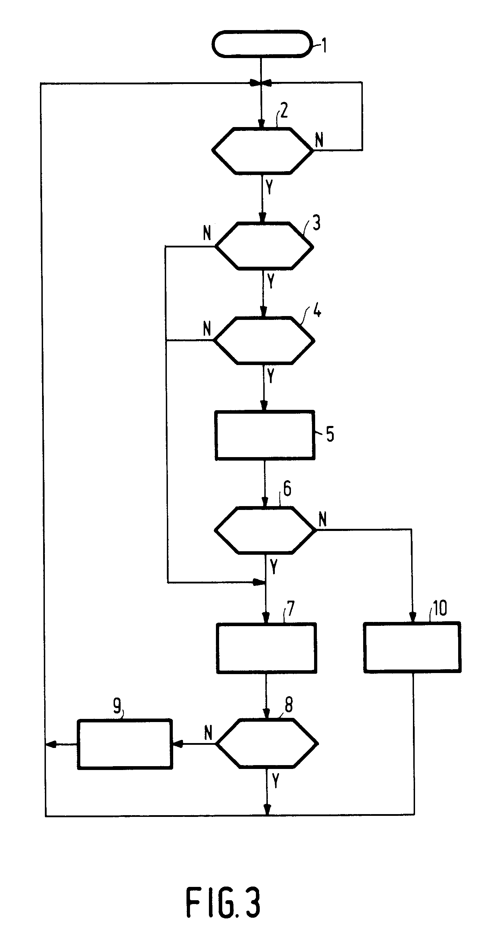

Fig. 3 shows the method according to the invention by way of a flow chart. The starting position is a position 1 in which the memory sites of M are filled with AFs, PI, PTY, PS, TP, TA, PIN and MF and the reception quality of at least the AFs of the active memory banks, i.e. the one in which the actual transmitter frequency is stored.

In a step 2 it is determined whether a better alternative for the actual transmitter in the AF list of the active memory bank is possible, i.e. whether a better signal reception is possible at a frequency in the relevant AF list than at the actual transmitter frequency.

If this is the case and if the actual transmitter does not transmit EON code words in the RDS signal, tuning to the better alternative, which thereby becomes the actual transmitter, takes place via a step 3 in step 7. Subsequently the reception of the correct PI code is checked in a step 8 (PI check). If the PI code is correct, i.e. if it conforms to the PI code of the AF list of the active memory bank, the starting position is reached again If the PI code is not correct, this alternative is rendered useless for a given period of time, for example 2 to 20 minutes and subsequently step 2 is performed again, this time without the alternative which has been rendered useless.

If a better alternative is found in step 2 for the actual transmitter and if the actual transmitter does transmit EON code words (step 3), it is determined in a step 4 whether the said better alternative with an AF in a frequency list of at least one other program or network has a mapped relationship. If this is not the case, the said step 7 is performed which is followed by the step 8 and possibly by the step 9.

If this better alternative forms part of a so-called mapped frequency pair, trio, etc. hereinafter briefly referred to as frequency set, the signal reception quality of any other frequency of such a frequency set is measured in a step 5 and compared in a step 6 with a preselected criterion. This criterion can be determined with reference to transmitter powers of transmitters to which the frequencies of the frequency set relate. If these transmitter powers are, for example, mutually equal, the frequencies of the frequency set should mutually substantially correspond in reception quality so as to comply with the criterion for a desired RDS transmitter.

If the signal quality at the frequencies of the frequency set in the said step 6 complies with the criterion which has been imposed, a flag signal is subsequently generated which authorizes a tuning to the said better alternative in the step 7 and a continuous tuning to the better alternative, thereby becoming the actual transmitter frequency, takes place in the case of a correct PI code.

If this criterion is not satisfied, the last-mentioned alternative is rendered useless in a step 10 for a given period of time, for example 10 minutes and subsequently the step 2 is performed again, this time without the alternative which has been rendered useless.

Since it is clear that the actual transmitter transmits EON code words with or without mapped frequencies already at a first reception of EON code words in the RDS signal of the actual transmitter, the steps 3 and 4 only relate to calling the information which relates thereto and which has previously been gathered. Consequently, these steps 3 and 4 can be performed together with the steps 5 and 6 within an inaudibly short period of time.

It will be evident that the invention is not limited to the embodiment shown. For example, it is quite possible to introduce the information about the said mapped frequencies without using EON code words, by hand or from a read-only memory into the memory circuit M and/or to perform a number of the afore-mentioned functions and steps of the control circuit MP in, for example the RDS decoding circuit DEC. It is also possible to use the flag signal for options other than the authorization of tuning to a better alternative. It will not be difficult to those skilled in the art to conceive suitable embodiments while using the inventive concept.

## Claims

1. A method of processing digital information of a radio data signal which is transmitted in a radio broadcasting signal with reference to at least first and second program identification codes of first and second program signals, respectively, and to a plurality of alternative frequencies per program identification code, said alternative frequencies being stored in first and second frequency lists allocated to the first and second program identification codes, characterized in that a frequency pair is formed from at least one alternative frequency in the first frequency list and an alternative frequency in the second frequency list, if the transmitters to which the two alternative frequencies relate have a substantially mutually equal transmitter location and transmitter range, the reception quality of the RF radio broadcasting signal of each transmitter of the frequency pair being measured and compared with a quality criterion and a flag signal being generated and applied to a flag signal processing unit if the reception quality of each one of the two alternative frequencies satisfies the quality criterion.

2. A method as claimed in Claim 1, characterized by a detection of a code word incorporated in the radio data signal and preceding two alternative frequencies which jointly form a frequency pair.

3. A method as claimed in Claim 1 or 2, characterized in that the flag signal processing unit authorizes a change-over between the tuning to alternative frequencies provided with a flag signal.

4. A method as claimed in any one of the preceding Claims, characterized in that a flag signal is generated if the field strengths of the two alternative frequencies of a frequency pair mutually substantially correspond to each other.

5. An FM receiver for receiving a digital radio data signal incorporated in an FM radio broadcasting signal, said receiver comprising an FM receiver section for tuning to a desired FM radio broadcasting signal and for processing the digital radio data signal to digital information relating to alternative frequencies which are grouped at least in accordance with first and second program identification codes, a control circuit and a memory circuit comprising at least first and second arrays of memory sites for storing the alternative frequencies grouped in accordance with the first and second program identification codes in first and second frequency lists, respectively, and a reception quality detector controlled by the control circuit, characterized in that the control circuit comprises means for forming a frequency pair from an alternative frequency in the first frequency list and an alternative frequency in the second frequency list, if the transmitters to which the two alternative frequencies relate have a substantially mutually equal transmitter location and transmitter range, means for activating the reception quality detector for measuring the reception quality of the RF radio broadcasting signal of each transmitter of the frequency pair, a comparison circuit for comparing the reception quality of said two transmitters with a quality criterion, a flag signal generating arrangement for generating a flag signal if the reception quality of each one of the two transmitters satisfies the quality criterion, and a flag signal processing circuit for processing the flag signal.

6. An FM receiver as claimed in Claim 5, characterized by a code word detector for detecting a code word incorporated in the radio data signal and preceding two alternative frequencies which jointly form a frequency pair.

7. An FM receiver as claimed in Claim 6, characterized in that the control circuit stores the said two alternative frequencies at mutually corresponding memory sites in the first and second frequency lists.

8. An FM receiver as claimed in Claim 7, characterized in that the flag signal processing circuit stores the flag signal of the flag signal generating arrangement in memory array at a memory site corresponding to the memory sites of the relevant frequency pair, and in that it comprises a flag detector for authorizing a change-over of the tuning to one of the alternative frequencies provided with a flag signal.

9. An FM receiver as claimed in Claim 5, characterized in that the comparison circuit compares the reception quality of each one of the two transmitters whose frequencies form a frequency pair with at least one threshold value and activates the flag signal generating arrangement if the reception quality of the two transmitters exceeds this threshold value.

10. An FM receiver as claimed in Claim 9, characterized in that the comparison circuit also mutually compares the reception quality of the two transmitters to which the frequency pair relates and activates the flag signal generating arrangement if the reception quality of the two transmitters is substantially mutually equal.

## Patentansprüche

1. Verfahren zur Verarbeitung von in einem Rundfunkdatensignal, das im rundfunksignal übertragen wird, enthaltenen digitalen Informationen bezüglich wenigstens erster und zweiter Programmidentifizierungscodes von jeweils ersten und zweiten Programmsignalen und bezüglich mehrerer alternativer Frequenzen pro Programmidentifzierungscode, wobei die besagten alternativen Frequenzen in ersten und zweiten Frequenzlisten gespeichert werden, die den ersten und zweiten Programmidentifizierungscodes zugeordnet sind, dadurch gekennzeichnet, daß aus mindestens einer alternativen Frequenz in der ersten Frequenzliste und einer alternativen Frequenz in der zweiten Frequenzliste ein Frequenzpaar gebildet wird, wenn die Sender, zu denen die beiden alternativen Frequenzen gehören, untereinander einen im wesentlichen gleichen Senderstandort und Sendebereich haben, die Empfangsqualität des HF-Rundfunksignals gemessen und mit einem Qualitätskriterium verglichen wird sowie ein Flaggensignal erzeugt und einer Flaggensignalverarbeitungseinheit zugeführt wird, wenn die Empfangsqualität jeder der beiden alternativen Frequenzen das Qualitätskriterium erfüllt.

2. Verfahren nach Anspruch 1, gekennzeichnet durch eine Detektierung eines Codewortes, das im Rundfunkdatensignal enthalten ist und den beiden alternativen Frequenzen vorangeht, die zusammen ein Frequenzpaar bilden.

3. Verfahren nach Anspruch 1 oder 2, dadurch gekennzeichnet, daß die Flaggensignalverarbeitungseinheit ein Umschalten der Abstimmung auf mit einem Flaggensignal versehene alternative Frequenzen autorisiert.

4. Verfahren nach einem der vorstehenden Ansprüche, dadurch gekennzeichnet, daß ein Flaggensignal erzeugt wird, wenn die Feldstärken der zwei alternativen Frequenzen eines Frequenzpaars einander im wesentlichen entsprechen.

5. FM-Empfänger zum Empfang eines im FM-Rundfunksignal enthaltenen digitalen Rundfunkdatensignals, wobei besagter Empfänger einen FM-Empfangsteil umfaßt zur Abstimmung auf ein gewünschtes FM-Rundfunksignal und zur Verarbeitung des digitalen Rundfunkdatensignals zu einer digitalen Information bezüglich alternativer Frequenzen, die zumindest nach ersten und zweiten Programmidentifizierungscodes gruppiert sind, eine Steuerschaltung und eine Speicherschaltung, die mindestens erste und zweite Felder von Speicherplätzen zur Speicherung der jeweils nach ersten und zweiten Programmidentifizierungscodes in ersten und zweiten Frequenzlisten gruppierten alternativen Frequenzen, sowie einen von der Steuerschaltung gesteuerten Empfangsqualititätsdetektor, dadurch gekennzeichnet, daß die Steuerschaltung Mittel umfaßt zur Bildung eines Frequenzpaars aus einer alternativen Frequenz in der ersten Frequenzliste und einer alternativen Frequenz aus der zweiten Frequenzliste, wenn die Sender, zu denen die beiden alternativen Frequenzen gehören, untereinander einen im wesentlichen gleichen Senderstandart und Sendebereich haben, Mittel zur Aktivierung des Empfangsqualitätsdetektors zur Messung der Empfangsqualität des HF-Rundfunksignals jedes Senders des Frequenzpaars, eine Vergleichsschaltung zum Vergleich der Empfangsqualität der besagten zwei Sender mit einem Qualitätskriterium, eine Flaggensignalerzeugungseinrichtung zur Erzeugung eines Flaggensignals, wenn jeder der beiden Sender das Qualitätskriterium erfüllt, sowie eine Flaggensignalverarbeitungsschaltung zur Verarbeitung des Flaggensignals.

6. FM-Empfänger nach Anspruch 5, gekennzeichnet durch einen Codewortdetektor zur Detektierung eines Codeworts, das im Rundfunkdatensignal enthalten ist und den beiden alternativen Frequenzen vorangeht, die zusammen ein Frequenzpaar bilden.

7. FM-Empfänger nach Anspruch 6, dadurch gekennzeichnet, daß die Steuerschaltung die besagten zwei alternativen Frequenzen an einander entsprechenden Speicherplätzen in den ersten und zweiten Frequenzlisten speichern.

8. FM-Empfänger nach Anspruch 7, dadurch gekennzeichnet, daß die Flaggensignalverarbeitungsschaltung das Flaggensignal der Flaggensignalerzeugungseinrichtung in einem Speicherfeld an einem Speicherplatz speichert, der den Speicherplätzen des betreffenden Frequenzpaars entspricht, und daß er einen Flaggendetektor enthält, um das Umschalten der Abstimmung auf eine der mit einem Flaggensignal versehene alternativen Frequenzen zu autorisieren.

9. FM-Empfänger nach Anspruch 5, dadurch gekennzeichnet, daß die Vergleichsschaltung die Empfangsqualität jeder der zwei Sender, deren Frequenzen ein Frequenzpaar bilden, mit mindestens einem Schwellenwert vergleicht und die Flaggensignalerzeugungsanordnung aktiviert, wenn die Empfangsqualität der beiden Sender diesen Schwellenwert überschreitet.

10. FM-Empfänger nach Anspruch 9, dadurch gekennzeichnet, daß die Vergleichsschaltung auch die Empfangsqualität der beiden zu dem Frequenzpaar gehörigen Sender miteinander vergleicht und die Flaggensignalerzeugungseinrichtung aktiviert, wenn die Empfangsqualität der beiden Sender untereinander im wesentlichen gleich ist.

## Revendications

1. Procédé de traitement d'informations numériques d'un signal de données radio qui sont transmises dans un signal de radiodiffusion avec référence à au moins un premier code et un deuxième code d'identification de programmme d'un premier signal et d'un deuxième signal de programme, respectivement, et à une pluralité d'autres fréquences par code d'identification de programme, lesdites autres fréquences étant stockées dans une première liste et une deuxième liste de fréquences attribuées au premier code et au deuxième code d'identification de programme, caractérisé en ce qu'une paire de fréquences est formée à partir d'au moins une autre fréquence de la première liste de fréquences et d'une autre fréquence de la deuxième liste de fréquences, si les émetteurs auxquels les deux autres fréquences se rapportent ont un emplacement d'émetteur et une portée d'émetteur en substance mutuellement égaux, la qualité de réception du signal de radiodiffusion RF de chaque émetteur de la paire de fréquences étant mesurée et comparée à un critère de qualité et un signal indicateur étant généré et appliqué à une unité de traitement des signaux indicateurs si la qualité de réception de chacune des deux autres fréquences satisfait au critère de qualité.

2. Procédé selon la revendication 1, caractérisé par une détection d'un mot de code incorporé au signal de données radio et précédant deux autres fréquences qui forment ensemble une paire de fréquences.

3. Procédé selon la revendication 1 ou 2, caractérisé en ce que l'unité de traitement des signaux indicateurs autorise une commutation entre des accords sur d'autres fréquences pourvues d'un signal indicateur.

4. Procédé selon l'une quelconque des revendications précédentes, caractérisé en ce qu'un signal indicateur est généré si les intensités de champ des deux autres fréquences d'une paire de fréquences correspondent en substance l'une à l'autre.

5. Récepteur FM destiné à recevoir un signal de données radio numériques incorporé à un signal de radiodiffusion FM, ledit récepteur comprenant une section de récepteur FM destinée à s'accorder sur un signal de radiodiffusion FM souhaité et à convertir le signal de données radio numériques en informations numériques se rapportant à d'autres fréquences qui sont groupées au moins selon le premier code et le deuxième code d'identification de programme, un circuit de commande et un circuit de mémoire comprenant au moins un premier réseau et un deuxième réseau d'emplacements de mémoire pour stocker les autres fréquences groupées selon le premier code et le deuxième code d'identification de programme dans la première liste et la deuxième liste de fréquences, respectivement, et un détecteur de qualité de réception commandé par le circuit de commande, caractérisé en ce que le circuit de commande comprend des moyens permettant de former une paire de fréquences à partir d'une autre fréquence de la première liste de fréquences et d'une autre fréquence de la deuxième liste de fréquences, si les émetteurs auxquels les deux autres fréquences se rapportent ont un emplacement d'émetteur et une portée d'émetteur en substance mutuellement égaux, des moyens pour activer le détecteur de qualité de réception pour mesurer la qualité de réception du signal de radiodiffusion RF de chaque émetteur de la paire de fréquences, un circuit de comparaison pour comparer la qualité de réception desdits deux émetteurs à un critère de qualité, un agencement générateur de signaux indicateurs pour générer un signal indicateur si la qualité de réception de chacun des deux émetteurs satisfait au critère de qualité, et un circuit de traitement des signaux indicateurs pour traiter le signal indicateur.

6. Récepteur FM selon la revendication 5, caractérisé par un détecteur de mot de code pour la détection d'un mot de code incorporé au signal de données radio et précédant deux autres fréquences qui forment ensemble une paire de fréquences.

7. Récepteur FM selon la revendication 6, caractérisé en ce que le circuit de commande stocke lesdites deux autres fréquences dans des emplacements de mémoire mutuellement correspondants de la première et de la deuxième listes de fréquences.

8. Récepteur FM selon la revendication 7, caractérisé en ce que le circuit de traitement des signaux indicateurs stocke le signal indicateur de l'agencement générateur de signaux indicateurs dans le réseau de mémoires à un emplacement correspondant aux emplacements de mémoire de la paire de fréquences concernées, et en ce qu'il comprend un détecteur de signal indicateur pour autoriser une commutation de l'accord vers l'une des autres fréquences pourvue d'un signal indicateur.

9. Récepteur FM selon la revendication 5, caractérisé en ce que le circuit de comparaison compare la qualité de réception de chacun des deux émetteurs dont les fréquences forment une paire de fréquence avec au moins une valeur de seuil et active l'agencement générateur de signaux indicateurs si la qualité de réception des deux émetteurs dépasse cette valeur de seuil.

10. Récepteur FM selon la revendication 9, caractérisé en ce que le circuit de comparaison compare également mutuellement la qualité de réception des deux émetteurs auxquels la paire de fréquences se rapporte et active l'agencement générateur de signaux indicateurs si la qualité de réception des deux émetteurs est en substance égale pour les deux.
